# EUROPEAN PATENT SPECIFICATION

(11) **EP 2 852 654 B1**
(45) Date of publication and mention of the grant of the patent: **26.07.2017**
(21) Application number: 13770705.5
(22) Date of filing: 22.05.2013
(51) Int. Cl.: C09K 11/62, H01L 33/50, C09K 11/02

(54) **ENHANCEMENT OF QUANTUM YIELD USING HIGHLY REFLECTIVE AGENTS**
VERBESSERUNG DER QUANTENAUSBEUTE MIT HOCHREFLEKTIERENDEN MITTELN
AMÉLIORATION DE RENDEMENT QUANTIQUE PAR UTILISATION D'AGENTS HAUTEMENT RÉFLÉCHISSANTS

(30) Priority: 22.05.2012 US 201261650238 P
(43) Date of publication of application: 01.04.2015
(73) Proprietor: Nanoco Technologies Ltd, Manchester M13 9NT (GB)
(72) Inventor: NASAANI, Imad, Manchester M20 2UL (GB); PANG, Hao, Manchester M33 6NF (GB)
(74) Representative: Dauncey, Mark Peter
(86) International application number: PCT/IB2013/001816
(87) International publication number: WO 2013/175317

(56) References cited:
- EP-A2- 2 214 218
- US-A1- 2008 173 886
- US-A1- 2011 068 322

## Description

### RELATED APPLICATIONS

### FIELD OF THE INVENTION

This invention relates generally to compositions of highly luminescent materials. The present invention relates more particularly to nanoparticle compositions having enhanced luminescent properties.

### BACKGROUND

There has been substantial interest in the preparation and characterization of compound semiconductors in the form of particles with dimensions in the order of 2-50 nanometers (nm), often referred to as quantum dots (QDs), nanoparticles, or nanocrystals. Interest has arisen mainly due to the size-related electronic properties of these materials that can be exploited in many commercial applications such as optical and electronic devices, biological labeling, solar cells, catalysis, biological imaging, light-emitting diodes, general space lighting, and electroluminescent and photoluminescent displays.

A particularly relevant area of interest is using QD-based emitters in backlighting for liquid crystal displays (LCDs). Conventional backlight units have consisted of a cold cathode fluorescent lamp (CCFL) and a diffuser sheet to give large areas of homogenous white light. Due to energy and size constraints, more recently RGB-LEDs have replaced the CCFL light source. A further development has been to use a blue LED excitation source in combination with a sheet containing a conventional phosphor, such as YAG, whereby the "phosphor layer" or "phosphor sheet" is located near or on top of the diffuser layer and away from the light/excitation source.

Currently phosphorescent materials used in down converting applications, absorb UV or mainly blue light and convert it to longer wavelengths, with most phosphors currently using trivalent rare-earth doped oxides or halophosphates. White emission is obtained by blending phosphors, which emit in the blue, green and red regions with that of a blue or UV emitting solid-state device. i.e. a blue light emitting LED plus a green phosphor such as, SrGa₂S₄:Eu²⁺, and a red phosphor such as, SrSiEu²⁺ or a UV light emitting LED plus a yellow phosphor such as, Sr₂P₂O₇:Eu²⁺;Mu²⁺, and a blue-green phosphor.

Presently white LEDs are made by combining a blue LED with a yellow phosphor however, colour control and colour rendering is poor when using this methodology due to lack of tunability of the LEDs and the phosphor. Moreover, conventional LED phosphor technology uses down converting materials that have poor colour rendering (i.e. colour rendering index (CRI) < 75) due to the lack of available phosphor colours.

There has been substantial interest in exploiting the properties of QDs as downconverting materials in LED applications, such as LCDs. These materials are of interest due to their size-tuneable electronic properties which can be exploited in many commercial applications. Two fundamental factors, both related to the size of the individual semiconductor nanoparticle, are responsible for their unique properties. The first is the large surface to volume ratio; as a particle becomes smaller, the ratio of the number of surface atoms to those in the interior increases. This leads to the surface properties playing an important role in the overall properties of the material. The second factor, which affects many materials including semiconductor nanoparticles, is a change in the electronic properties of the materials with size; because of quantum confinement effects the band gap gradually becomes larger as the size of the particle decreases. This effect is a consequence of the confinement of an 'electron in a box' giving rise to discrete energy levels similar to those observed in atoms and molecules, rather than a continuous band as observed in the corresponding bulk semiconductor material. Thus, for a semiconductor nanoparticle, because of the physical parameters, the "electron and hole", produced by the absorption of electromagnetic radiation, a photon, with energy greater then the first excitonic transition, are closer together than they would be in the corresponding macrocrystalline material; moreover the Coulombic interaction cannot be neglected. This leads to a narrow bandwidth emission, which is dependent upon the particle size and composition of the nanoparticle material. Thus, QDs have higher kinetic energy than the corresponding macrocrystalline material and consequently the first excitonic transition (band gap) increases in energy with decreasing particle diameter.

Core semiconductor nanoparticles, which consist of a single semiconductor material along with an outer organic passivating layer, tend to have relatively low quantum efficiencies due to electron-hole recombination occurring at defects and dangling bonds situated on the nanoparticle surface which can lead to non-radiative electron-hole recombinations.

One method to eliminate defects and dangling bonds on the inorganic surface of the QD is to overcoat the nanoparticles with a homogeneous shell of a second semiconductor. This semiconductor material typically has a much wider band-gap than that of the core to suppress tunnelling of the charge carriers from the core to the newly formed surface atoms of the shell. The shell material must also have a small lattice mismatch to that of the core material. Lattice mismatch arises primarily because of the differences in bond lengths between the atoms in the core and in the shell. Although the differences in the lattice mismatch between the core and shell materials may only be a few percent it is enough to alter both the kinetics of shell deposition and particle morphology as well as the quantum yield (QY) of the resultant particles. QY is simply the ratio of the number of photons emitted by a sample to the number of photons absorbed by the sample, i.e., (# photons emitted)/(# photons absorbed), and can be thought of as a measure of the relative "brightness" of a QD-based material. Small lattice mismatch is essential to ensure epitaxial growth of the shell on the surface of the core particle to produce a "core-shell" particle with no or minimum defects at the interface that could introduce non-radiative recombination pathways that reduce the photoluminescence quantum yield (PLQY) of the particle. One example is a ZnS shell grown on the surface of a CdSe or InP core. The lattice mismatch of some of the most common shell materials relative to CdSe is 3.86% for CdS, 6.98% for ZnSe and 11.2% for ZnS.

Another approach is to prepare a core-multi shell structure where the "electron-hole" pair is completely confined to a single shell layer consisting of a few monolayers of a specific material such as a QD-quantum well structure. Here, the core is of a wide band gap material, followed by a thin shell of narrower band gap material, and capped with a further wide band gap layer, such as CdS/HgS/CdS grown using substitution of Hg for Cd on the surface of the core nanocrystal to deposit just a few monolayers of HgS which is then over grown by a monolayer of CdS. The resulting structures exhibit clear confinement of photo-excited carriers in the HgS layer, which result in a high PLQY and improved photochemical stability.

To add further stability to QDs and help to confine the electron-hole pair one of the most common approaches is to grow thick and robust shell layers around the core. However, because of the lattice mismatch between the core and shell materials, the interface strain accumulates dramatically with increasing shell thickness, and eventually can be released through the formation of misfit dislocations, degrading the optical properties of the QDs. This problem can be circumvented by epitaxially growing a compositionally graded alloy layer on the core as this can help to alleviate the strain at the core-shell interface. For example in order to improve the structural stability and quantum yield of a CdSe core, a graded alloy layer of Cd₁₋ₓZnₓSe_{1-y}S_{y} can be used in place of a shell of ZnS directly on the core. Because of the gradual change in shell composition and lattice parameters the resulting graded multi-shell QDs are very well electronically passivated with PLQY values in the range of 70-80% and present enhanced photochemical and colloidal stability compared to simple core-shell QDs.

Doping QDs with atomic impurities is an efficient way also of manipulating the emission and absorption properties of the nanoparticle. Procedures for doping wide band gap materials, such as zinc selenide and zinc sulfide, with manganese and copper (ZnSe : Mn or ZnS : Cu), have been developed. Doping with different luminescence activators in a semiconducting nanocrystal can tune the photoluminescence and electroluminescence at energies even lower than the band gap of the bulk material, whereas the quantum size effect can tune the excitation energy with the size of the QDs without having a significant change in the energy of the activator related emission. Dopants include main group or rare earth elements, often a transition metal or rare earth element, such as, Mn⁺ or Cu²⁺.

The coordination around the atoms on the surface of any core, core-shell or core-multi shell, doped or graded nanoparticle is incomplete and the non-fully coordinated atoms have dangling bonds which make them highly reactive and can lead to particle agglomeration. This problem is overcome by passivating (capping) the "bare" surface atoms with protecting organic groups.

The use of QDs in light emitting devices has some significant advantages over the use of the more conventional phosphors such as the ability to tune the emission wavelength, strong absorption properties and low scattering if the QDs are monodispersed. However the methods used so far are challenging due to chemical incompatibility between the outer organic surfaces of the QDs and the types of host materials in which the QDs are supported. QDs can suffer from agglomeration when formulating into these materials and, once incorporated, can suffer from photo-oxidation as a result of the migration of oxygen through the host material to the surfaces of the QDs, which can ultimately lead to a drop in quantum yield. Although reasonable devices can be made under laboratory conditions, there remain significant challenges to replicate this under commercial conditions on a large scale. For example, at the mixing stage the QDs need to be stable to air.

Devices incorporating a light emitting layer where semiconductor QDs are used in place of the conventional phosphors have been described, however, due to problems relating to processability and the stability of the QD-containing materials during and after layer fabrication, the only types of QD material that have been successfully incorporated into such layers are relatively conventional II-VI or IV-VI QD materials, e.g. CdSe, CdS and PbSe. Cadmium and other restricted heavy metals used in conventional QDs are highly toxic elements and represent a major concern in commercial applications. The inherent toxicity of cadmium-containing QDs prevents their use in any applications involving animals or humans. For example recent studies suggest that QDs made of a cadmium chalcogenide semiconductor material can be cytotoxic in a biological environment unless protected. Specifically, oxidation or chemical attack through a variety of pathways can lead to the formation of cadmium ions on the QD surface that can be released into the surrounding environment. Although surface coatings such as ZnS can significantly reduce the toxicity, it may not completely eliminate it because QDs can be retained in cells or accumulated in the body for a long period of time, during which their coatings may undergo some sort of degradation exposing the cadmium-rich core.

The toxicity affects not only the progress of biological applications but also other applications including optoelectronic and communication because heavy metal-based materials are widespread in many commercial products including household appliances such as IT & telecommunication equipment, lighting equipment, electrical & electronic tools, toys, leisure & sports equipment. A legislation to restrict or ban certain heavy metals in commercial products has been already implemented in many regions of the world. For example starting 1 July 2006, the European Union directive 2002/95/EC, known as the "Restrictions on the use of Hazardous Substances in electronic equipment" (or RoHS), banned the sale of new electrical and electronic equipment containing more than agreed levels of lead, cadmium, mercury, hexavalent chromium along with polybrominated biphenyl (PBB) and polybrominated diphenyl ether (PBDE) flame retardants. This law required manufacturers to find alternative materials and develop new engineering processes for the creation of common electronic equipment. In addition, on 1 June 2007 a European Community Regulation came into force concerning chemicals and their safe use (EC 1907/2006). The Regulation deals with the Registration, Evaluation, Authorisation and Restriction of Chemical substances and is known as "REACH". The REACH Regulation gives greater responsibility to industry to manage the risks from chemicals and to provide safety information on the substances. It is anticipated that similar regulations will be extended worldwide including China, Korea, Japan and the US.

As mentioned above, QDs, and especially cadmium-free QDs, tend to be sensitive to oxidation by oxygen, which causes their QY to decrease over time. A need exists to increase the stability and luminescent properties, i.e., the QY of cadmium-free QDs to improve the efficiency and longevity of light-emitting applications of these materials. Methods used to increase the stability of QD-based lighting systems include incorporating the QDs into oxygen-repelling materials, such as polymers. Such polymers can be in many forms, for example, beads or sheets. Moreover, the QDs can be incorporated into beads, which themselves are incorporated into other forms, such as sheets or layers. While such protective measures are needed to protect the QDs from oxygen, cadmium-free QDs tend to be sensitive to handling and it is often the case that the handling required to incorporate the QDs into oxygen-repelling materials itself causes the QY of the QDs to decrease. Thus, any factor that maximizes the QY of the final QD-based system is potentially important for achieving cadmium-free QD-based commercial products.

US2008/173886A1 discloses a population of quantum dots and non-absorbing light scattering dielectric particles dispersed in a matrix material.

### SUMMARY

The present disclosure is directed to multicomponent materials with improved light-emitting properties i.e., with improved light emission. The multicomponent materials include a phosphor material such as QDs and a reflective material such as barium sulfate suspended or embedded in a matrix material. The matrix material is typically a polymeric material. The multicomponent materials may be in the form of beads, sheets, and/or sheets-of-beads, for example.

Primarily, the multicomponent materials described herein are for use in backlighting for LCDs, but they can also be used in other applications, such as color conditioning of ambient lighting. The phosphors within the multicomponent material absorb primary light from a primary light source, for example, a blue-emitting or UV-emitting LED. The photo-excited phosphors emit light at a longer wavelength than that of the absorbed light. In other words, the phosphors down-convert the absorbed light. In certain configurations, the multicomponent material absorbs a portion of the primary light and also transmits a portion of the primary light. Thus, the total light emanating from the multicomponent material is a mixture of the primary light (short wavelength) and emitted light (longer wavelength). Using a blue LED as a primary light source and a multicomponent material containing green-emitting and red-emitting phosphors yields white light, i.e., a combination of blue green and red.

### BRIEF DESCRIPTION OF THE DRAWINGS

For a more complete understanding of the present invention, including features and advantages, reference is now made to the detailed description of the invention along with the accompanying figures:
Figure 1 illustrates an apparatus for light emitting light.
Figure 2 illustrates an alternative embodiment of an apparatus for emitting light.
Figure 3 illustrates the effect of BaSO4 on the quantum yield of films of InP/ZnS QDs.
Figure 4 illustrates the effect of BaSO4 on the quantum yield of films of InP/ZnS QDs.
Figure 5 illustrates the effect of BaSO4 on the quantum yield of films of InP/ZnS QDs.
Figure 6 illustrates the effect of BaSO4 on the external quantum efficiency of films of InP/ZnS QDs.
Figure 7 illustrates the effect of BaSO4 on the quantum yield and external quantum efficiency of films of InP/ZnS QDs.

### DETAILED DESCRIPTION

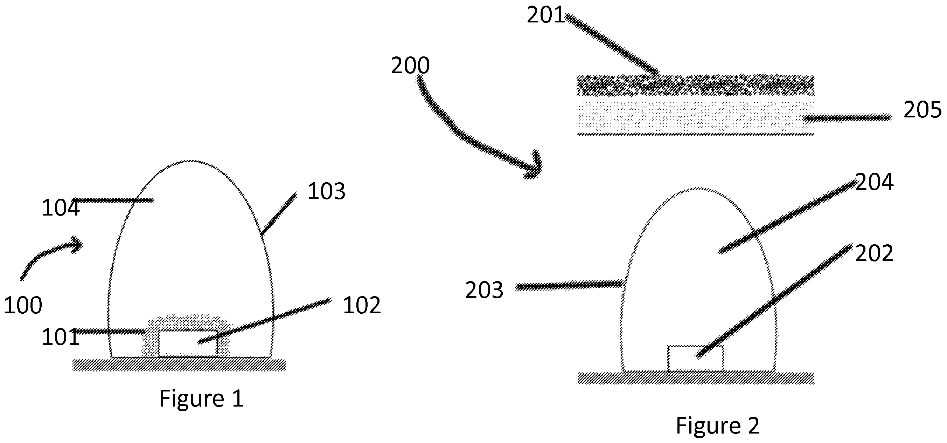

Figure 1 illustrates an embodiment of a light emitting device 100, which uses a phosphor material 101 to down convert primary light from solid-state LED chip 102. In other words, light from LED chip 102 stimulates phosphor material 101 to emit light. Both the phosphor and the solid-state LED chip are contained within a standard LED package 103, which may also contain an LED encapsulant material 104, as is known to those of skill in the art.

Figure 2 illustrates an alternative embodiment of a light emitting device 200, which also includes a phosphor material 201 to down-convert primary light from solid-state LED chip 202. The embodiment illustrated in Figure 2 includes an LED package 203, which may also contain an LED encapsulant 204. The embodiment of Figure 2 differs from that of Figure 1 in that the phosphor material 201 is disposed as a remote layer, for example, on a diffuser 205, instead of being disposed directly on LED chip 202.

Particularly suitable phosphors for the multicomponent materials described herein are QDs, such as those described in co-owned U.S. Pat. Nos. 7,588,828, issued September 15, 2009, 7,803,423, issued September 28, 2010, 7,985,446, issued July 26, 2011, 7,867,556, issued January 11, 2011, and 7,867,557, issued January 11, 2011. High luminous efficiency can be achieved with a UV light source exciting the QDs which removes the need of filters, hence reducing the loss of light intensity. The colour range attainable in the device is enhanced and can be gradually tuned by varying the size or the composition of the QDs, for example, a range of colours can be obtained from blue to deep red to span the entire visible spectrum by varying the size of CdSe or InP QDs. The size of InAs and PbSe QDs can be tuned to cover most of the near- and middle-infrared regions. QD displays yield more purity in colours than other types of display technologies because QDs exhibit very narrow emission bandwidths and can create pure blue, green, and red to generate all other colours with the results of an improved viewing experience for the end user. By tailoring their synthesis, the QDs can be easily dispersed into aqueous or organic mediums enabling fast and economic device manufacturing with standard printing or other solution-processable techniques; this also provides an opportunity to create printable and flexible devices.

The QDs can contain ions selected from group 11, 12, 13, 14, 15 and/or 16 of the periodic table, and/or may contain one or more types of transition metal ion or d-block metal ion. The QDs may contain one or more semiconductor material selected from the group consisting of CdS, CdSe, CdTe, ZnS, ZnSe, ZnTe, InP, InAs, InSb, AIP, AIS, AIAs, AISb, GaN, GaP, GaAs, GaSb, PbS, PbSe, Si, Ge, MgS, MgSe, MgTe and combinations thereof./ZnS/ZnO.

Examples of reflecting materials are particulate materials that are compatible with both the matrix material and the QD phosphors. Examples of reflecting materials include barium sulfate, titanium dioxide, polytetrafluoro ethylene (PTFE), aluminum silicate, and yttrium aluminum garnet (YAG). Barium sulfate has been found to be particularly suitable.

Barium sulfate is a light reflective material and insoluble in solvents. In addition, it is inert and does not react with QDs or other phosphors. Thus, it acts as a mirror when mixed along with highly concentrated QDs solution. In such solutions, the barium sulfate particles reduce reabsorption of light emitted from the QDs, thereby increasing photon extraction from the solution. The solution therefore has a higher effective QY than a solution of QDs alone. Without being bound by theory or any physical mode of activity, it is also believed that barium sulfate increases light extraction through the generation of light coupling between surface plasmons and emitted light from fluorescent materials.

Examples of matrix materials include polymer matrices, such as described in co-owned U.S. Pat. Nos. 7,544,725, issued June 9, 2009, 7,674,844, issued March 9, 2010, and U.S. Application Publication Pub. Nos. 2011/0068321, published March 24, 2011 and 2011/0068322, published March 24, 2011. The polymeric medium is preferably an optically transparent medium comprising a material selected from the group consisting of a polymer, a resin, a monolith, a glass, a sol gel, an epoxy, a silicone and a (meth)acrylate. The polymeric medium may comprise a material selected from the group consisting of poly(methyl (meth)acrylate), poly(ethylene glycol dimethacrylate), polyvinyl acetate), poly(divinyl benzene), poly(thioether), silica, polyepoxide and combinations thereof.

The matrix material may be selected from a wide variety of polymers whether organic or inorganic, glass, water soluble or organic solvent soluble, biological or synthetic. For example, the following simple linear chain polymers may be used polyacrylate, polycarbonate, polystyrene, polyethylene, polypropylene, poly ketone, polyether ether ketone, polyesters, polyamide, polyimide, polyacrylamide, polyolefines, polyacetylene, polyisoprene, polybutadiene, PVDF, PVC, EVA, PET, polyurethane, cellulose polymers (e.g., ethylcellulose, isopropylmethylcellulose phthalate, nitrocellulose). Further examples include crosslinked polymers and/or copolymers, triblock copolymers and UV- and thermal curing epoxy. Suitable polymers may be selected from the group consisting of polystyrene / toluene matrix, trimethylol propane trimethacrylate / lauryl methacrylate matrix, trimethylol propane trimethacrylate / lauryl methacrylate / polyisobutylene matrix, trimethylol propane trimethacrylate / lauryl methacrylate / PIPS matrix, isobornyl acrylate / dipropyleneglycol diacrylate matrix, acrylic-polystyrene / toluene matrix, and polycarbonate. Clay materials such as bentonite, kaolin, fumed silica (e.g. Cab-O-Sil^{™}), fumed alumina, fumed zinc oxide, inorganic polymers can be used as the host matrix medium alone or as additives to organic polymers in order to improve the performance of the final material. The method according to the present disclosure may employ any of the polymers and materials indicated above alone or in combination with one or more other suitable polymers and materials.

The QD/reflective material compositions described herein can be formulated into inks. Inks are made by mixing transparent base ink with various types of fluorescent pigments. Although these pigments can provide the desired degree of luminescence, in many cases due to their ability to scatter the light they can make the ink opaque which is often an undesirable side effect. Opacity becomes an issue when high loadings of pigments are necessary to achieve the desired brightness or when the ink is used as a primary ink to be combined by overprinting to create secondary and tertiary colors. For example, a transparent blue ink that is overprinted on top of a yellow transparent ink will results into a green ink. On the contrary, an opaque blue ink overprinted on top of another ink will hide the underlying ink independently of its color and the final ink will continue to appear blue to the viewer because of its opacity.

The introduction of QDs and reflective material into a solid state matrix, such as a 'bead material', is of great advantage. QD-beads can be incorporated into a polymer matrix or medium to form a QD-bead ink by dispersing the desired amount of QD-bead material in the desired amount of a suitable polymer. The resulting composite is mixed thoroughly to provide a homogeneous ink that can be cured according to the specific curing procedure for that particular polymer used and provide a simple and straightforward way of fabricating a luminescent QD-bead ink.

Bead-based inks can offer other advantages over free 'bare' QD-inks. By incorporating QDs and reflective materials into stable beads it is possible to protect the otherwise reactive QDs from the potentially damaging surrounding chemical environment. Moreover, by placing a number of QDs into a single bead, the subsequent QD-bead is more stable than the bare QDs to mechanical and thermal processing that the QD-ink often must undergo during the fabrication of luminescent products. Additional advantages of QD-containing beads over bare QDs include greater stability to air, moisture and photo-oxidation which might open the possibility of handling QD-inks in air and remove the need of expensive handling processes that require an inert atmosphere thus reducing significantly the manufacturing costs.

The size of the beads can be tuned and are typically from 50 nm to 0.5 mm in diameter following tailored encapsulation protocols, providing a way to control the ink viscosity. This is very important because the viscosity dictates how ink flows through a mesh, how it dries, and how well it adheres to a substrate. If the viscosity can be controlled by the size of the beads, then it is possible to eliminate the practice of adding significant amounts of thinner to change the viscosity making the process simpler and less expensive.

Because of the nature of the encapsulation process, not only is QD aggregation prevented, yielding a uniform layer, but also the QD surface is not disrupted or drastically modified and the QDs retain their original electronic properties so that the specifications of the QD-bead ink can be controlled tightly. QD-beads permit efficient colour mixing of the quantum dots in the ink because the mixing can be either within the QD-containing beads, i.e. each bead contains a number of different size/colour emitting QDs, or a mixture of differently coloured beads with all the QDs within a specific bead being of the same size/colour, i.e. some beads containing all blue quantum dots, some all green quantum dots and some all red quantum dots.

It is possible to encapsulate hydrophobic coated-QDs into beads composed of a hydrophilic polymer to impart novel surface properties (for example water solubility). This is of particular importance for making water-based QD inks, which have many positive qualities and in particular are environmentally friendly. There are many regulations that have identified organic solvents typically used as vehicles in printing inks as hazardous. Hazardous waste regulations restrict disposal options for all wastes mixed with solvents from these inks that are usually of organic in nature (e.g., toluene, ethanol, isopropanol) and highly flammable. The chemicals that derive from the break-down of these wastes are also toxic and special measures (like for example special filters) have to be employed in the printing industry to trap these chemicals and avoid their release in the environment. Water-based inks provide an attractive alternative to these organic solvents and a mean of eliminating both pollution and many of the regulatory constraints on the printing process.

Under specific experimental conditions the bead coating can be selectively modified or removed during/prior certain stages of the ink preparation meaning that the ink can be interpreted as a medium to deliver the QDs and the reflective material. Thus QD-beads represent a way to the controlled release and delivery of QDs which could be important for example to protect the QDs and separate them from incompatible substances during certain stages of the printing process or to increase the affinity of the QDs in a specific ink solvent.

A QD-bead ink can include green light emitting QD-silica beads in a polystyrene / toluene matrix. A polystyrene / toluene mixture is first formed to which is then added a suitable amount of the QD-beads, in this case InP/ZnS core/shell QD-beads. The resulting mixture is then processed (e.g. heating, mixing etc) to ensure satisfactory dispersion of the QD-bead particles in the polystyrene / toluene mixture to yielded a transparent green QD-bead ink.

Alternatively, a QD-bead ink can include red light emitting acrylate beads in an LED acrylate matrix. A mixture containing an initiator, Irgacure 819, trimethylol propane trimethacrylate (TMPTM) and lauryl methacrylate is initially formed. InP/ZnS core/shell QD-acrylate beads are then dispersed in the acrylate mixture to yield a red QD-bead ink.

A QD-bead ink can include red light emitting acrylate beads in a flexible acrylate matrix comprising trimethylol propane trimethacrylate (TMPTM) and polyisobutylene (PIB). In an alternative embodiment, PIB can be substituted with PIPS. A mixture containing an initiator, Irgacure 819, and TMPTM is formed. A separate mixture of PIB and lauryl methacrylate is also formed. The amount of TMPTM used in this embodiment is relatively less than the amount used in the second preferred embodiment to ensure that the acrylate matrix is less crosslinked and therefore more flexible than the acrylate matrix produced in the second preferred embodiment. The two mixtures are then combined to yield a yellowish ink matrix. InP/ZnS core/shell QD-acrylate beads are then dispersed in the yellowish matrix to yield a red QD-bead ink.

Examples of polymerisation methods that may be used to construct QD/reflective material-containing beads include suspension, dispersion, emulsion, living, anionic, cationic, RAFT, ATRP, bulk, ring closing metathesis and ring opening metathesis but not exclusive to. Initiation of the polymerisation reaction may be caused by any suitable method, which causes the monomers to react with one another, such as by the use of free radicals, light, ultrasound, cations, anions, or heat. A preferred method is suspension polymerisation involving thermal curing of one or more polymerisable monomers from which the optically transparent medium is to be formed. Said polymerisable monomers preferably comprise methyl (meth)acrylate, ethylene glycol dimethacrylate and vinyl acetate. This combination of monomers has been shown to exhibit excellent compatibility with existing commercially available LED encapsulants and has been used to fabricate a light emitting device exhibiting significantly improved performance compared to a device prepared using essentially prior art methodology. Other preferred polymerisable monomers are epoxy or polyepoxide monomers, which may be polymerised using any appropriate mechanism, such as curing with ultraviolet irradiation.

QD/reflective material-containing microbeads can be produced by dispersing a known population of QDs and reflective material within a polymer matrix, curing the polymer and then grinding the resulting cured material. This is particularly suitable for use with polymers that become relatively hard and brittle after curing, such as many common epoxy or polyepoxide polymers (e.g. OptocastTM 3553 from Electronic Materials, Inc., USA).

Beads may be generated simply by adding QDs and the reflective material to the mixture of reagents used to construct the beads. In some instances QDs (nascent QDs) will be used as isolated from the reaction employed to synthesise them and are thus generally coated with an inert outer organic ligand layer. In an alternative procedure a ligand exchange process may be carried out prior to the bead forming reaction. Here one or more chemically reactive ligands (for example this might be a ligand for the QDs which also contains a polymerisable moiety) are added in excess to a solution of nascent QDs coated in an inert outer organic layer. After an appropriate incubation time the QDs are isolated, for example by precipitation and subsequent centrifugation, washed and then incorporated into the mixture of reagents used in the bead forming reaction/process.

Both QD/reflective material incorporation strategies will result in statistically random incorporation of the QDs and reflective material into the beads and thus the polymerisation reaction will result in beads containing statistically similar amounts of the QDs. It will be obvious to one skilled in the art that bead size can be controlled by the choice of polymerisation reaction used to construct the beads and additionally once a polymerisation method has been selected bead size can also be controlled by selecting appropriate reaction conditions, e.g. in a suspension polymerisation reaction by stirring the reaction mixture more quickly to generate smaller beads. Moreover the shape of the beads can be readily controlled by choice of procedure in conjunction with whether or not the reaction is carried out in a mould. The composition of the beads can be altered by changing the composition of the monomer mixture from which the beads are constructed. Similarly the beads can also be cross-linked with varying amounts of one or more cross-linking agents (e.g. divinyl benzene). If beads are constructed with a high degree of cross-linking, e.g. greater than 5 mol% cross-linker, it may be desirable to incorporate a porogen (e.g. toluene or cyclohexane) during the reaction used to construct the beads. The use of a porogen in such a way leaves permanent pores within the matrix constituting each bead. These pores may be sufficiently large to allow the ingress of QDs into the bead.

QDs and reflective material can also be incorporated in beads using reverse emulsion based techniques. The QDs/reflective material may be mixed with precursor(s) to the optically transparent coating material and then introduced into a stable reverse emulsion containing, for example, an organic solvent and a suitable salt. Following agitation the precursors form microbeads encompassing the QDs, which can then be collected using any appropriate method, such as centrifugation. If desired, one or more additional surface layers or shells of the same or a different optically transparent material can be added prior to isolation of the QD-containing beads by addition of further quantities of the requisite shell layer precursor material(s).

In respect of the second option for incorporating QDs and reflective material into beads, the QDs and reflective material can be immobilised in polymer beads through physical entrapment. For example, a solution of QDs and reflective material in a suitable solvent (e.g. an organic solvent) can be incubated with a sample of polymer beads. Removal of the solvent using any appropriate method results in the QDs and reflective material becoming immobilised within the matrix of the polymer beads. The QDs and reflective material remain immobilised in the beads unless the sample is resuspended in a solvent (e.g. organic solvent) in which the QDs are freely soluble. Optionally, at this stage the outside of the beads can be sealed. Another option is to physically attach at least a portion of the semiconductor nanoparticles to prefabricated polymeric beads. Said attachment may be achieved by immobilisation of the portion of the semiconductor nanoparticles within the polymer matrix of the prefabricated polymeric beads or by chemical, covalent, ionic, or physical connection between the portion of semiconductor nanoparticles and the prefabricated polymeric beads. Examples of prefabricated polymeric beads comprise polystyrene, polydivinyl benzene and a polythiol.

Optically transparent media which are sol-gels and glasses that are intended to incorporate QDs and reflective material may be formed in an analogous fashion to the method used to incorporate QDs and reflective material into beads during the bead forming process as described above. For example, a single type of QD (e.g. one colour) and reflective material may be added to the reaction mixture used to produce the sol-gel or glass. Alternatively, two or more types of QD (e.g. two or more colours) and reflective material may be added to the reaction mixture used to produce the sol-gel or glass. The sol-gels and glasses produced by these procedures may have any shape, morphology or 3-dimensional structure. For example, the particles may be spherical, disc-like, rod-like, ovoid, cubic, rectangular or any of many other possible configurations.

By incorporating QDs and reflective material into beads in the presence of materials that act as stability-enhancing additives, and optionally providing the beads with a protective surface coating, migration of deleterious species, such as moisture, oxygen and/or free radicals, is eliminated or at least reduced, with the result of enhancing the physical, chemical and/or photo-stability of the semiconductor nanoparticles.

An additive may be combined with "naked" semiconductor nanoparticles and precursors at the initial stages of the production process of the beads. Alternatively, or additionally, an additive may be added after the semiconductor nanoparticles have been entrapped within the beads.

The additives which may be added singly or in any desirable combination during the bead formation process can be grouped according to their intended function as follows:
Mechanical sealing: Fumed silica (e.g.Cab-O-Sil^{™}), ZnO, TiO₂, ZrO, Mg stearate, Zn Stearate, all used as a filler to provide mechanical sealing and/or reduce porosity;
Capping agents: Tetradecyl phosphonic acid (TDPA), oleic acid, stearic acid, polyunsaturated fatty acids, sorbic acid. Zn methacrylate, Mg stearate, Zn Stearate, isopropyl myristate. Some of these have multiple functionality and can act as capping agents, free radical scavengers and/or reducing agents;
Reducing agents: Ascorbic acid palmitate, alpha tocopherol (vitamin E), octane thiol, butylated hydroxyanisole (BHA), butylated hydroxytoluene (BHT), gallate esters (propyl, lauryl, octyl and the like), and a metabisulfite (e.g. the sodium or potassium salt);
Free radical scavengers: benzophenones; and
Hydride reactive agents: 1,4-butandiol, 2-hydroxyethyl methacrylate, allyl methacrylate, 1,6 heptadiene-4-ol, 1,7 octadiene, and 1,4 butadiene.

### EXAMPLES

The following examples are included for the sake of completeness of disclosure and to illustrate the methods of making the compositions and composites of the present invention as well as to present certain characteristics of the compositions.

### EXAMPLE 1: Effect of BaSO4 in toluene or acrylate resin without thickening agent.

Quantum dots (InP/ZnS) were prepared as described in U.S. Pat. No. 7,588,828, issued September 15, 2009, the contents of which are incorporated herein by reference. Quantum yield of the QDs (0.5ml of 6.6 Optical Density QDs/ml) in toluene was measured using a Hamamatsu integrating sphere to give a QY of 57%. When 5 mg of BaSO4 was added to the 0.5ml 20 OD QDs/ml toluene solution and stirred by vortex measurement by Hamamatsu indicated a QY of 63%. Thus, the QY of the QDs was improved by 6% by adding BaSO4. The results of these measurements are summarized in the below table.

| InP/ZnS QD (20 OD) | QY | Wavelength (nm) | FWHM (nm) |
|---|---|---|---|
| QDs in toluene | 57% | 642 | 82 |
| Mixture of QDs and BaSO4 in toluene | 63% | 629 | 77 |

Two batches of InP/ZnS QDs were prepared according to the method described in U.S. Pat. No. 7,588,828, issued September 15, 2009. QD resins were prepared from three concentrations (3.7, 9.1 and 20 OD) of each batch of QDs in lauryl methacrylate (LMA)/trimethylolpropane trimethacrylate (TMPMA). Poly(butadiene) diacrylate coagent (Sartomer SR307) and the QDs were stirred in toluene overnight. The toluene was removed and the mixture was mixed with LMA and photoinitiator (Irgacure Irg819) and TMPMA. The QY of each of the resins with and without BaSO4 (2 % wt/wt) was measured before and after UV curing. The results are tabulated below.

| | QY | Wavelength (nm) | FWHM (nm) |
|---|---|---|---|
| Batch 1 (3.7 OD) | | | |
| QDs in Resin only before curing | 64% | 601 | 58 |
| Mixture of QDs and BaSO4 in Resin before curing | 61% | 602 | 58 |
| QDs in Resin only after curing | 51% | 603 | 59 |
| Mixture of QDs and BaSO4 in Resin after curing | 56% | 604 | 58 |
| Batch 1 (9.1OD) | | | |
| QDs in Resin only before curing | 65% | 605 | 58 |
| Mixture of QDs and BaSO4 in Resin before curing | 65% | 605 | 57 |
| QDs in Resin only after curing | 51% | 607 | 58 |
| Mixture of QDs and BaSO4 in Resin after curing | 52% | 610 | 59 |
| Batch 1 (200D) | | | |
| QDs in Resin only before curing | 63% | 610 | 58 |
| Mixture of QDs and BaSO4 in Resin before curing | 66% | 609 | 58 |
| QDs in Resin only after curing | 53% | 612 | 58 |
| Mixture of QDs and BaSO4 in Resin after curing | 56% | 616 | 57 |
| Batch 2 (3.7 OD) | | | |
| QDs in Resin only before curing | 69% | 606 | 58 |
| Mixture of QDs and BaSO4 in Resin before curing | 66% | 603 | 57 |
| QDs in Resin only after curing | 55% | 606 | 57 |
| Mixture of QDs and BaSO4 in Resin after curing | 56% | 605 | 58 |
| Batch 2 (9.1 OD) | | | |
| QDs in Resin only before curing | 72% | 610 | 57 |
| Mixture of QDs and BaSO4 in Resin before curing | 72% | 608 | 56 |
| QDs in Resin only after curing | 54% | 613 | 57 |
| Mixture of QDs and BaSO4 in Resin after curing | 64% | 613 | 56 |
| Batch 2 (20 OD) | | | |
| QDs in Resin only before curing | 73% | 614 | 57 |
| Mixture of QDs and BaSO4 in Resin before curing | 74% | 613 | 57 |
| QDs in Resin only after curing | 60% | 617 | 56 |
| Mixture of QDs and BaSO4 in Resin after curing | 63% | 621 | 55 |

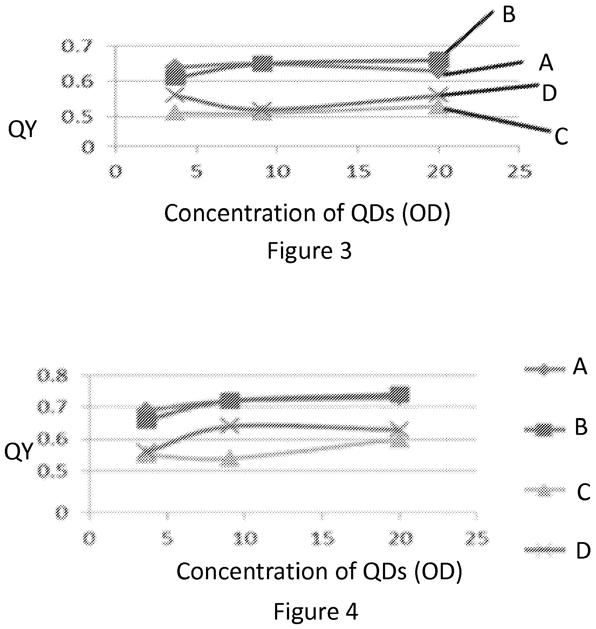

The QY measurements of Batch 1 and Batch 2 are illustrated in Figures. 3 and 4, respectively. In both Figures 3 and 4, line A corresponds to QDs in resin before curing, line B corresponds to the mixture of QDs and BaSO4 in resin before curing, line C corresponds to QDs in cured resin, and line D corresponds to the mixture of QDs and BaSO4 in cures resin. The addition of BaSO4 enhances the QY of both the cured and uncured QD resins.

### EXAMPLE 2: BARIUM SULFATE STUDY (CONCENTRATIONS 0-5% W/V)

InP/ZnS QDs were prepared according to the method described in U.S. Pat. 7,588,828, issued September 15, 2009. QD resins were prepared (10, 20, 30 and 40 OD) with the QDs in lauryl methacrylate (LMA)/trimethylolpropane trimethacrylate (TMPMA). Poly(butadiene) diacrylate coagent (Sartomer SR307) and the QDs were stirred in toluene overnight. The toluene was removed and the mixture was mixed with LMA and photoinitiator (Irgacure Irg819) and TMPMA. The QY the resins incorporating 0 - 5% w/v BaSO4 was measured after UV curing. The results are tabulated below.

| | | | | | | | |
|---|---|---|---|---|---|---|---|
| [BaSO4] (% w/v) | 0 | 0.5 | 1 | 2 | 3 | 4 | 5 |
| QE (10 OD/3mL) (%) | 54.1 | 54.1 | 54.7 | 54.7 | 55.3 | 55.8 | 56.8 |
| PL (nm) | 616 | 614 | 615 | 613 | 613 | 612 | 611 |
| FWHM (nm) | 61 | 61 | 60 | 59 | 61 | 59 | 60 |
| QE (20 OD/3mL) (%) | 52 | 51.2 | 51.6 | 53.2 | 53.3 | 53.7 | 55.5 |
| PL (nm) | 623 | 622 | 623 | 621 | 620 | 618 | 617 |
| FWHM (nm) | 62 | 61 | 61 | 60 | 60 | 59 | 59 |
| QE (30 OD/3mL) (%) | 49.8 | 49.3 | 50.3 | 51 | 51.8 | 51.9 | 53 |
| PL (nm) | 629 | 628 | 627 | 625 | 625 | 624 | 622 |
| FWHM (nm) | 63 | 62 | 61 | 59 | 59 | 58 | 58 |
| QE (40 OD/3mL) (%) | 47.9 | 47.1 | 47.2 | 48 | 48.6 | 49.8 | 51 |
| PL (nm) | 632 | 630 | 628 | 625 | 627 | 624 | 622 |
| FWHM (nm) | 63 | 62 | 62 | 62 | 60 | 59 | 60 |

External quantum efficiency (EQE) increased with loading of barium sulfate in acrylate resins. Higher loading of barium sulfate gave higher EQE and causes a blue shift of the photoluminescence (PL) wavelength. An incremental blue shift is observed because apparently BaSO4 is reducing reabsorption (reabsorption causes red shift). Higher loading of BaSO4 also decreases the FWHM of the emission peak. The same enhancement effect of barium sulfate was observed on all samples with various QD concentrations. This suggests that the presence of barium sulfate in samples reduced dots aggregation, limited light scattering, and guided light travel more efficiently to a detector.

Higher QD concentration caused lower EQE and higher PL and FWHM due to QD aggregation. The maximum 5-6% increase of EQE was found on samples with 5% loading of barium sulfate. The best results (56.8% & 55.5%) came from 10 OD/3ml & 20 OD/3ml QD concentration with 5% Barium sulfate loading. All figures showing in the above table are mean values of three measurements.

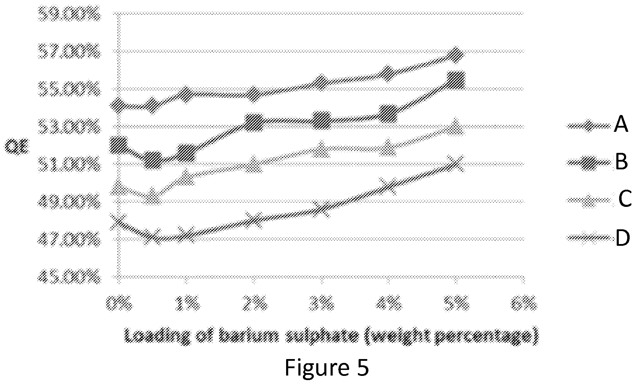

Figure 5 illustrates the effect of BaSO4 concentration on the various QD resins. In Figure 5, line A corresponds to a QD concentration of 10 OD/3ml, line B to a QD concentration of 20 OD/3ml, line C to a QD concentration of 30 OD/3ml, and line D to a QD concentration of 40 OD/3ml.

The QY of the QD/acrylate resins having BaSO4 loading of 0-5 % were measured using a Labsphere integrating sphere. The results are shown in the following table.

| Barium Sulfate concentration (w/w; BaSO₄/resins) | EQE (10 OD/3ml; in cured acrylate resins) | EQE (20 OD/3ml; in cured acrylate resins) | EQE (30 OD/3ml; in cured acrylate resins) | EQE (400D/3ml; in cured acrylate resins) |
|---|---|---|---|---|
| 0% | 32.2% | 33.2% | 33.1% | 32.5% |
| 0.5% | 31.4% | 37.4% | 35.5% | 36.8% |
| 1% | 36.3% | 42% | 36% | 37.1% |
| 2% | 38.9% | 40% | 39.9% | 40% |
| 3% | 41.2% | 39.7% | 40% | 38.9% |
| 4% | 41% | 41.8% | 44% | 42.4% |
| 5% | 43.5% | 43.4% | 42% | 44.6% |

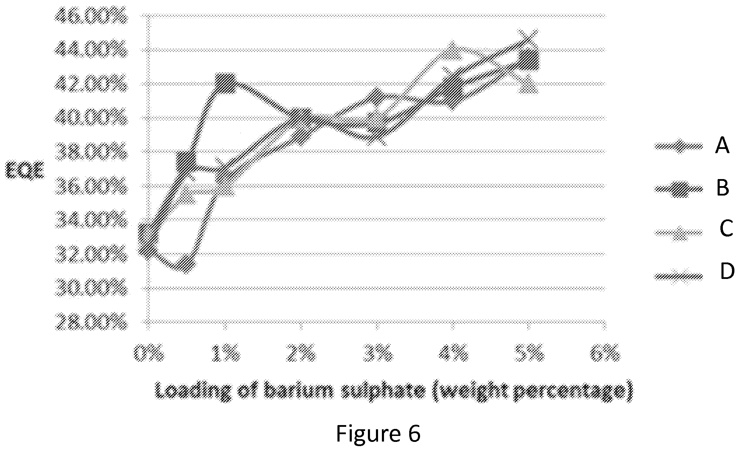

EQE increased with loading of barium sulfate. Higher loading of Barium sulfate resulted in higher EQE. See Figure 6, wherein line A corresponds to a QD concentration of 10 OD/3ml, line B to a QD concentration of 20 OD/3ml, line C to a QD concentration of 30 OD/3ml, and line D to a QD concentration of 40 OD/3ml. The same enhancement effect of barium sulfate was observed on all samples with various QD concentrations.

The maximum 30-38% increase of EQE was found on samples with 5% loading of barium sulfate by labsphere. The greater percentage increase of EQE in labsphere measurements compared to that in Hamamatsu measurements suggest that barium sulfate works much more efficiently to guide light travel out of inner systems rather than by surface reflection.

All figures showing in the above table are mean values of three measurements.

### EXAMPLE 3: BARIUM SULFATE STUDY ON 100D/3ML (CONCENTRATIONS 0-20% W/V)

The following table tabulates Labshere measurements of 10 OD / 3 ml. resins of InP/ZnS QDs, prepared as described above. All EQE data showing in the table are the mean values of three experiments.

| Barium Sulfate concentration (w/ml; BaSO₄/resins) | EQE 7days later (10 OD/3ml; in cured acrylate resins) |
|---|---|
| 0% | 43.9% |
| 2.5% | 48.5% |
| 5% | 51.7% |
| 7.5% | 49% |
| 10% | 40.5% |
| 15% | 42.8% |
| 20% | 41.8% |

The following table tabulates Hamamatsu measurements of 10 OD / 3 ml resins of InP/ZnS QDs, prepared as described above. All EQE data showing in the above table are the mean values of three experiments.

| Barium Sulfate concentration (w/ml; BaSO₄/resins) | QE(10 OD/3ml) | PL (nm) | FWHM (nm) |
|---|---|---|---|
| 0% | 50% | 614 | 61 |
| 2.5% | 52.4% | 612 | 60 |
| 5% | 53.2% | 611 | 60 |
| 7.5% | 53.9% | 612 | 60 |
| 10% | 54.7% | 609 | 60 |
| 15% | 55.3% | 610 | 60 |
| 20% | 56.0% | 610 | 60 |

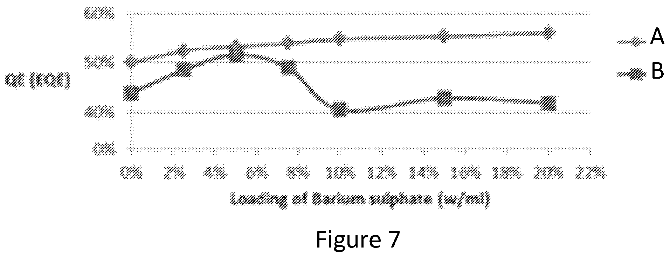

Figure 7 illustrates the effect of BaSO4 loading on the QE of QD resins, as measured by Hamamatsu integrating sphere (A) and Labsphere integrating sphere (B).

Labsphere measurements of resins of 20 OD/3ml InP/ZnS QDs loaded with BaSO4 with silicone coupling between sample and excitation light are shown in the following table. Adding a silicone resin underneath the QD film helps waveguide the blue excitation light that is coming from the LED (the light source). This way the blue light does not pass through air phase, which has a different refractive index and is not scattered or diverted away from the sample or around the edges of the sample.

| Barium Sulfate concentration (w/ml; BaSO₄/resins) | EQE (200D/3ml; JPM080 in cured acrylate resins) |
|---|---|
| 0% | 46.3% |
| 2.5% | 51.7% |
| 5% | 51% |
| 7.5% | 51.8% |

Labsphere measurements of 20 OD/3ml InP/ZnS QDs loaded with BaSO4 without silicone coupling between sample and excitation light are shown in the following table.

| Barium Sulfate concentration (w/ml; BaSO₄/resins) | EQE (200D/3 ml; JPM080 in cured acrylate resins) |
|---|---|
| 0% | 42.4% |
| 2.5% | 44.5% |
| 5% | 45.1% |
| 7.5% | 44.6% |

Hamamatsu measurements of 20 OD/3ml InP/ZnS QDs loaded with BaSO4 are shown in the following table.

| Barium Sulfate concentratio n (w/ml; BaS0₄/resin s) | QE (200D/3 ml) | PL (nm) | FWHM (nm) |
|---|---|---|---|
| 0% | 55.5% | 624 | 58 |
| 2.5% | 57.1% | 624 | 56 |
| 5% | 58.6% | 619 | 56 |
| 7.5% | 59.6% | 621 | 55 |

All QE, PL and FWHM data showing in the above table are the mean values of three experiments.

### EXAMPLE 4: TiO2 AS REFLECTING MATERIA

InP/ZnS QDs were prepared and loaded into resins as described above, along with titanium oxide as a reflecting agent. The table below shows the QY and EQE of 20 OD films as a function of TiO2 loading.

| TiO₂ (%) | QY (%) | EQE (%) |
|---|---|---|
| 0 | 56 | 49.5 |
| 1 | 60 | 40.8 |
| 2 | 61 | 37.7 |
| 3 | 59 | 25 |
| 4 | 58 | 21.6 |
| 5 | 59 | 21.1 |

### EXAMPLE 5: ALUMINUM SILICATE AS A REFLECTING MATERIAL

InP/ZnS QDs were prepared and loaded into resins as described above, along with varying amounts of aluminum silicate as a reflecting material. The table below shows the QY and EQE of 20 OD QD films as a function of aluminum silicate loading.

| Aluminum silicate (%) | QY (%) (Hamamatsu) | EQE (%) (Labsphere) |
|---|---|---|
| Control (no additives) | 51.9 | 46.3 |
| 0 (but 5% BaSO4) | 54.5 | 42.7 |
| 1 | 51.3 | 46.2 |
| 2 | 49.6 | 41.1 |
| 3 | 50.3 | 39.8 |
| 4 | 49.7 | 28.8 |
| 5 | 50.1 | 38.7 |
| 7 | 47.2 | 31 |

### EXAMPLE 6: PTFE AS A REFLECTING MATERIAL

The table below shows QY and EQE measurements for films prepared as described above, but using PTFE as the reflecting material.

| PTFE (%, wt./v) | QY (%) (Hamamatsu) | EQE (%) (Labshpere) |
|---|---|---|
| 0 | 59.3 | 54.0 |
| 0.5 | 60.3 | 59.0 |
| 1.0 | 61.3 | 52.0 |
| 3.0 | 60.5 | 57.9 |
| 5.0 | 62.0 | 53.1 |

## Claims

1. A composition comprising:
a population of quantum dot (QD) phosphors and a reflective material, both suspended in a primary matrix material, wherein the matrix material comprises polymer beads.

2. The composition of claim 1, wherein the population of QD phosphors comprises QDs comprising a semiconductor material selected from the group consisting of CdS, CdSe, CdTe, ZnS, ZnSe, ZnTe, InP, InAs, InSb, AlP, AlS, AlAs, AlSb, GaN, GaP, GaAs, GaSb, PbS, PbSe, Si, Ge, MgS, MgSe, MgTe and combinations thereof

3. The composition of claim 1, wherein the population of QD phosphors comprises QDs that do not contain Cd.

4. The composition of claim 1, wherein the population of QD phosphors comprise QDs comprising InP.

5. The composition of claim 1, wherein the population of QD phosphors comprise QDs comprising a core of a first semiconductor material and at least a first shell of a semiconductor material.

6. The composition of claim 1, wherein the composition exhibits light-stimulated emission having a quantum yield of at least 50 % or at least 60 %.

7. The composition of claim 1, wherein the reflective material comprises particles of an inorganic material.

8. The composition of claim 1, wherein the reflective material comprises particles of material selected from the group consisting of barium sulfate, titanium dioxide, polytetrafluoro ethylene (PTFE), aluminum silicate, and yttrium aluminum garnet (YAG).

9. The composition of claim 1, wherein the primary matrix material is a liquid, optionally wherein:
(i) the liquid comprises a solvent and a population of monomers capable of reacting to form a polymer; or
(ii) the liquid comprises a solvent and a polymer; or
(iii) the liquid is a printable ink.

10. The composition of claim 1, wherein the matrix material comprises a polymer film.

11. The composition of claim 1, wherein composition comprises about 0.5 to about 20 % reflective material.

12. An apparatus comprising:
a primary light source and a secondary light source configured to absorb primary light from the primary light source and to emit secondary light, wherein
the secondary light source comprises a population of quantum dot (QD) phosphors and a reflective material, both suspended in a primary matrix material, wherein the matrix material comprises polymer beads.

13. The apparatus of claim 12, wherein the primary light source is a light emitting diode (LED).

14. The apparatus of claim 12, wherein the secondary light source is a polymer film.

15. The apparatus of claim 12, wherein the apparatus comprises one or more components of a liquid crystal display (LCD).

## Patentansprüche

1. Zusammensetzung, Folgendes beinhaltend:
eine Population von Quantenpunkt-(QD-)Phosphoren und ein reflektierendes Material, welche beide in einem Primärmatrixmaterial suspendiert sind, wobei das Matrixmaterial Polymerperlen enthält.

2. Zusammensetzung nach Anspruch 1, bei welcher die Population von QD-Phosphoren QDs beinhaltet, die ein Halbleitermaterial beinhalten, ausgewählt aus der Gruppe, bestehend aus CdS, CdSe, CdTe, ZnS, ZnSe, ZnTe, InP, InAs, InSb, AlP, AIS, AlAs, AlSb, GaN, GaP, GaAs, GaSb, PbS, PbSe, Si, Ge, MgS, MgSe, MgTe und Kombinationen hieraus.

3. Zusammensetzung nach Anspruch 1, bei welcher die Population von QD-Phosphoren QDs beinhaltet, die kein Cd enthalten.

4. Zusammensetzung nach Anspruch 1, bei welcher die Population von QD-Phosphoren QDs beinhaltet, die InP beinhalten.

5. Zusammensetzung nach Anspruch 1, bei welcher die Population von QD-Phosphoren QDs beinhaltet, die einen Kern aus einem ersten Halbleitermaterial und mindestens eine erste Schale aus einem Halbleitermaterial enthalten.

6. Zusammensetzung nach Anspruch 1, bei welcher die Zusammensetzung eine lichtstimulierte Emission aufweist, welche eine Quantenausbeute von mindestens 50 % oder mindestens 60 % besitzt.

7. Zusammensetzung nach Anspruch 1, bei welcher das reflektierende Material Partikel von anorganischem Material beinhaltet.

8. Zusammensetzung nach Anspruch 1, bei welcher das reflektierende Material Partikel von Material beinhaltet, ausgewählt aus der Gruppe, bestehend aus Bariumsulfat, Titandioxid, Polytetrafluorethylen (PTFE), Aluminiumsilikat und Yttrium-Aluminium-Granat (YAG).

9. Zusammensetzung nach Anspruch 1, bei welcher das Primärmatrixmaterial eine Flüssigkeit ist, und wobei optionsweise:
(i) die Flüssigkeit ein Lösemittel und eine Population von Monomeren beinhaltet, die reaktionsfähig zur Bildung eines Polymers sind; oder
(ii) die Flüssigkeit ein Lösemittel und ein Polymer beinhaltet; oder
(iii) die Flüssigkeit eine druckbare Tinte ist.

10. Zusammensetzung nach Anspruch 1, bei welcher das Matrixmaterial einen Polymerfilm beinhaltet.

11. Zusammensetzung nach Anspruch 1, bei welcher die Zusammensetzung etwa 0,5 bis etwa 20 % reflektierendes Material beinhaltet.

12. Vorrichtung, Folgendes beinhaltend:
eine Primärlichtquelle und eine Sekundärlichtquelle, konfiguriert zur Absorption von Primärlicht von der Primärlichtquelle und zur Emission von Sekundärlicht, wobei
die Sekundärlichtquelle eine Population von Quantenpunkt-(QD-)Phosphoren und ein reflektierendes Material beinhaltet, welche beide in einem Primärmatrixmaterial suspendiert sind, wobei das Matrixmaterial Polymerperlen enthält.

13. Vorrichtung nach Anspruch 12, bei welchem die Primärlichtquelle eine lichtemittierende Diode (LED) ist.

14. Vorrichtung nach Anspruch 12, bei welcher die Sekundärlichtquelle ein Polymerfilm ist.

15. Vorrichtung nach Anspruch 12, bei welcher die Vorrichtung eine oder mehrere Komponenten einer Flüssigkristallanzeige (LCD) beinhaltet.

## Revendications

1. Composition comprenant :
une population de phosphores à points quantiques (QD) et un matériau réfléchissant, tous deux en suspension dans un matériau de matrice primaire, dans laquelle le matériau de matrice comprend des billes de polymère.

2. Composition selon la revendication 1, dans laquelle la population de phosphores à QD comprend des QD comprenant un matériau semi-conducteur sélectionné dans le groupe constitué par CdS, CdSe, CdTe, ZnS, ZnSe, ZnTe, InP, InAs, InSb, AlP, AlS, AlAs, AlSb, GaN, GaP, GaAs, GaSb, PbS, PbSe, Si, Ge, MgS, MgSe, MgTe et des combinaisons de ceux-ci.

3. Composition selon la revendication 1, dans laquelle la population de phosphores à QD comprend des QD qui ne contiennent pas de Cd.

4. Composition selon la revendication 1, dans laquelle la population de phosphores à QD comprend des QD comprenant InP.

5. Composition selon la revendication 1, dans laquelle la population de phosphores à QD comprend des QD comprenant un coeur d'un premier matériau semi-conducteur et au moins une première coque d'un matériau semi-conducteur.

6. Composition selon la revendication 1, dans laquelle la composition présente une émission stimulée par la lumière ayant un rendement quantique d'au moins 50 % ou d'au moins 60 %.

7. Composition selon la revendication 1, dans laquelle le matériau réfléchissant comprend des particules d'un matériau inorganique.

8. Composition selon la revendication 1, dans laquelle le matériau réfléchissant comprend des particules de matériau sélectionnées dans le groupe constitué par le sulfate de barium, le dioxyde de titane, le polytétrafluoroéthylène (PTFE), le silicate d'aluminium et le grenat d'yttrium et d'aluminium (GYA).

9. Composition selon la revendication 1, dans laquelle le matériau de matrice primaire est un liquide, facultativement dans laquelle :
(i) le liquide comprend un solvant et une population de monomères capables de réagir pour former un polymère ; ou
(ii) le liquide comprend un solvant et un polymère ; ou
(iii) le liquide est une encre d'impression.

10. Composition selon la revendication 1, dans laquelle le matériau de matrice comprend un film polymère.

11. Composition selon la revendication 1, dans laquelle la composition comprend environ 0,5 à environ 20 % de matériau réfléchissant.

12. Appareil comprenant :
une source de lumière primaire et une source de lumière secondaire configurée pour absorber la lumière primaire en provenance de la source de lumière primaire et pour émettre une lumière secondaire, dans lequel
la source de lumière secondaire comprend une population de phosphores à points quantiques (QD) et un matériau réfléchissant, tous deux en suspension dans un matériau de matrice primaire, dans lequel le matériau de matrice comprend des billes de polymère.

13. Appareil selon la revendication 12, dans lequel la source de lumière primaire est une diode électroluminescente (LED).

14. Appareil selon la revendication 12, dans lequel la source de lumière secondaire est un film polymère.

15. Appareil selon la revendication 12, dans lequel l'appareil comprend un ou plusieurs composants d'un affichage à cristaux liquides (LCD).
